Europäisches Patentamt

European Patent Office

Office européen des brevets

(11) Publication number: **0 228 764**
A1

## (12) EUROPEAN PATENT APPLICATION

(21) Application number: 86307435.7

(22) Date of filing: 29.09.86

(51) Int. Cl.⁴: **H 01 L 27/06**
**H 01 L 29/80**

(30) Priority: 25.10.85 JP 237343/85

(43) Date of publication of application:
15.07.87 Bulletin 87/29

(84) Designated Contracting States:
DE FR GB IT

(71) Applicant: HITACHI, LTD.
6, Kanda Surugadai 4-chome Chiyoda-ku
Tokyo 100(JP)

(72) Inventor: Hatta, Yasushi
16-6-701, Hongo 3-chome Bunkyo-ku
Tokyo(JP)

(72) Inventor: Mitsusada, Kazumichi
30-45, Nakajima-cho
Kodaira-shi Tokyo(JP)

(72) Inventor: Tanaka, Hirotoshi
808-3, Tsurushima Uenohara-machi
Kitatsuru-gun Yamanashi(JP)

(72) Inventor: Shigeta, Junji
22-16, Kitayama-cho 2-chome
Fucyu-shi Tokyo(JP)

(72) Inventor: Matsunaga, Nobutoshi
1-34, Ohkubo 1-chome
Shinjiku-ku Tokyo(JP)

(72) Inventor: Kotera, Nobuo
18-3-301, Minami-cho 2-chome
Kokubunji-shi Tokyo(JP)

(72) Inventor: Hashimoto, Norikazu
19-14, Nanyoudai 2-chome
Hachiohji-shi Tokyo(JP)

(74) Representative: Calderbank, Thomas Roger et al,
MEWBURN ELLIS & CO. 2/3 Cursitor Street
London EC4A 1BQ(GB)

(54) Semiconductor device having at least one field-effect transistor with controlled source drain current.

(57) A semiconductor device has an FET (Qe,Qd) in which the current flowing between the source and drain (4) of the FET is controlled in accordance with the amount by which a depletion layer extends towards the channel region of the FET in response to a voltage applied to the gate. In order to achieve stable operation, particularly when the junction temperature rises, the FET (Qe,Qd) is operated in a region of its characteristic in which the current does not depend on the junction temperature. For example, with the gate and source connected together, the FET should have a threshold voltage of −1.2 V or less when the junction temperature is 25°C.

FIG. 3

## SEMICONDUCTOR DEVICE

The present invention relates to a semiconductor device and, more particularly, to a semiconductor integrated circuit device having at least one field-effect transistor.

One type of semiconductor integrated circuit has already been proposed which employs a metal Schottky barrier gate field-effect transistor (hereinafter referred to as a "MES(metal semiconductor)FET") provided on a compound semiconductor substrate, e.g., gallium arsenide (GaAs) substrate. Since the electron mobility in the gallium arsenide substrate is greater than in a single crystal silicon semiconductor substrate, this MESFET permits an increase in the operating speed of the device.

A MESFET comprises, for example, a lightly doped n-type channel region, a gate electrode provided on this channel region so as to define a Schottky junction, and a pair of $n^+$ type semiconductor regions employed as source and drain regions respectively. The drain current (the current flowing between the source and the drain) of the MESFET may then be controlled in accordance with the amount by which a depletion layer extends from the Schottky junction toward the channel region.

Inverter circuits, which are used as basic circuits for providing logic functions or memory functions, are often arranged in combination with a depletion type n-channel MESFET serving as a load element and a depletion or enhancement type n-channel MESFET serving as a driving element. This is because the mobility of holes in a gallium arsenide substrate is so small that it is substantially equal to that in a single crystal silicon semiconductor substrate, and the use of a p-type MESFET therefore prevents increase in the operating speed of the device.

Such a MESFET is mentioned in, for example, the November 8, 1982, issue of "Nikkei Electronics", pp.112 to 114, published by Nikkei McGraw-Hill.

It has been found that such an inverter circuit, composed of depletion and enhancement type MESFETs, involves the following problem.

During the operation of a semiconductor integrated circuit, when the junction temperature rises, there is an increase in the drain current of the depletion type MESFET, serving as a load element in the inverter circuit. In consequence, the power dissipation increases, and resulting thermal run-away may cause the semiconductor integrated circuit device to be destroyed.

The present invention therefore seeks to provide a semiconductor device which is able to operate in a stable manner, preferably even when the junction temperature rises.

The present invention therefore proposes that the FET is operated in a region of its characteristic in which the current flowing between source and drain does not depend on the junction temperature, or in which the current decreases with rise in junction temperature.

In this way it becomes possible to prevent any increase in the drain current of a field-effect transistor in which the drain current is controlled in accordance with the degree by which a depletion layer extends, even when the junction temperature rises. It also becomes possible to prevent any increase in the power dissipation in a field-effect transistor in which the drain current is controlled in accordance with the degree by which a depletion layer extends.

Thus, according to one aspect of the invention, there may be provided a field-effect transistor in which the drain current is controlled in accordance with the amount by which a depletion layer extends and which is so arranged that the drain current does not change or decreases as the junction temperature rises. This arrangement enables the power dissipation of the field-effect transistor to remain unchanged or decrease as the junction temperature rises. It is therefore possible to prevent destruction of a semiconductor integrated circuit incorporating the field-effect transistor due to thermal run-away.

In accordance with a second aspect of the invention, a MESFET on a compound semiconductor substrate has a threshold voltage of -1.2 V or lower when the junction temperature is 25°C. Then, by connecting together the gate and source of the MESFET, it may be used as a load element in an inverter. A pair of such inverters with inputs cross-coupled may thus be used in a flip-flop circuit of a memory cell.

Embodiments of the invention will now be described in detail, by way of example, with reference to the accompanying drawings, in which:

Fig. 1 is a circuit diagram of an inverter circuit employing a MESFET according to the present invention;

Fig. 2 is a sectional view showing the structure of the MESFET according to the present invention which is employed in the inverter circuit shown in Fig. 1;

Fig. 3 is a graph showing the relationship between the gate-source voltage and threshold voltage and the drain current of the MESFET;

Fig. 4 is a graph showing the relationship between the threshold voltage and the changing rate of drain current in accordance with the rise in the junction temperature;

Fig. 5 is a graph showing the relationship between the junction temperature and the power dissipation;

Fig. 6 is a circuit diagram of an SRAM memory cell employing a MESFET according to the present invention; and

Fig. 7 is a circuit diagram of an FLSC circuit employing a MESFET according to the present invention.

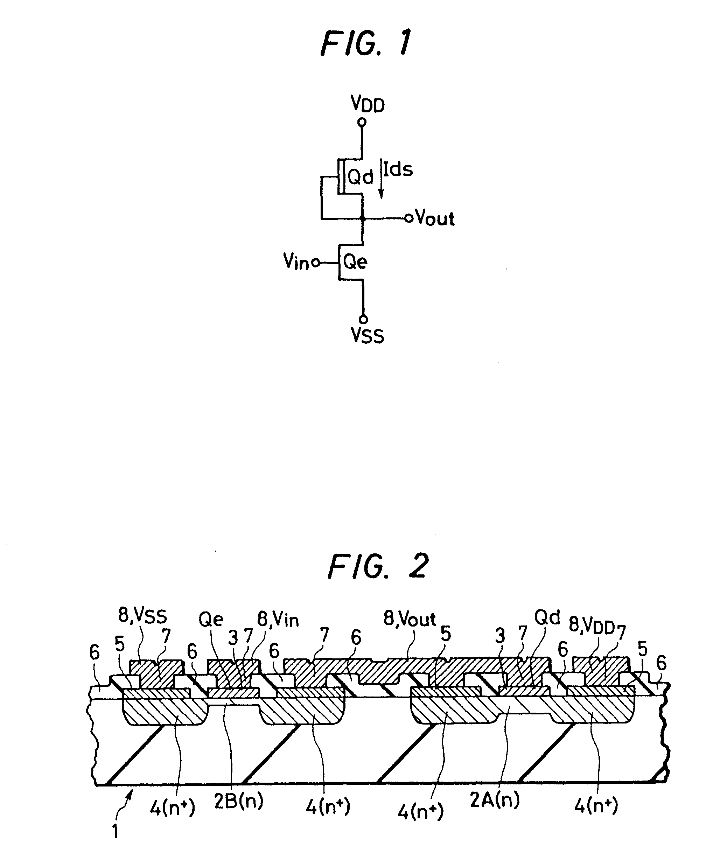

Fig. 1 shows an inverter circuit having a depletion type MESFET according to the present invention. This inverter circuit consists of a depletion type MESFET Qd and an enhancement type MESFET Qe.

The drain of the MESFET Qd is connected to a supply voltage $V_{DD}$ (e.g., the operating voltage of the circuit, i.e., 2.0 V) and the source is connected to both the gate electrode and an output terminal $V_{out}$. The MESFET Qd is used as a load element.

The source of the MESFET Qe is connected to a reference voltage $V_{SS}$ (e.g., the circuit earth potential, i.e., 0 V) and the drain is connected to both the source region of the MESFET Qd and the output terminal $V_{out}$. The gate electrode of the MESFET Qe is adapted to serve as an input terminal $V_{in}$ to which is input an input signal, e.g., either a low-level signal of 0 V or a high-level signal of 0.7 V.

The structures of the MESFETs Qd and Qe are shown in Fig. 2 which is a sectional view thereof.

The MESFETs Qd and Qe are, as shown in Fig. 2, formed on a semiconductor substrate 1 of gallium arsenide (GaAs). The substrate 1 is made of an undoped single crystal grown by the known Liquid Encapsulated Czochralski (LEC) method and has a relatively high resistivity (giving it semiinsulating properties).

The MESFET Qd comprises an n-type semiconductor region 2A which serves as a channel region, a gate electrode 3 formed on the main surface of the substrate 1, and a pair of $n^+$-type semiconductor regions 4 which are integral with the semiconductor region 2A and serve as source and drain regions respectively. The MESFET Qd has its threshold voltage preferably set at -1.2 V in accordance with the present invention, in order to prevent the drain current from increasing even when the junction temperature rises. For this purpose, the impurity density of the region 2A is $1 \times 10^{18}/cm^3$, and its depth is 180 nm. The region 2A can be formed by implanting silicon ions, being an n-type impurity, into the substrate 1 at a concentration of $4 \times 10^{12}/cm^2$ and at an energy of 75 keV. This ion implantation is carried out before the formation of the gate electrode 3. Annealing is effected after the ion implanation at 800°C for 20 minutes.

The MESFET Qe comprises an n-type semiconductor region 2B which serves as a channel region, a gate electrode 3 provided on the main surface of the substrate 1, and a pair of $n^+$-type semiconductor regions 4 which are integral with the semiconductor region 2B and respectively serve as source and drain regions. The MESFET Qe has its threshold voltage set at +0.2 V so that it is an enhancement type MESFET. For this purpose, the impurity density of the region 2B is $5 \times 10^{17}/cm^3$, and its depth is 100 nm. The region 2B is formed by implanting silicon ions into the substrate 1 at a concentration of $2 \times 10^{12}/cm^2$ and at an energy of 75 keV.

The regions 4 of the MESFETs Qd and Qe have an impurity density of $1 \times 10^{19}/cm^3$ and a depth of 220 nm. Silicon ions to form the regions 4 are implanted into the substrate 1 mainly using the gate electrodes 3 as a mask.

The ion implantation is effected at a concentration of 2 x $10^{13}/cm^2$ and at an energy of 150 keV. The above-described annealing at 800°C for 20 minutes is carried out as a common annealing treatment after the completion of ion implantation for forming the regions 2A, 2B and 4. In addition, each gate electrode 3 makes a Schottky junction with the semiconductor region 2A and 2B and controls the amount by which a depletion layer extends from the junction toward the semiconductor region 2A or 2B in accordance with the voltage applied thereto. Each gate electrode 3 is made of a metal which is capable of forming a Schottky junction together with the n-type region 2A and 2B, for example, tungsten silicide (W $Si_{0.5}$) film formed by CVD or sputtering.

Electrodes 5 are in ohmic contact with the semiconductor regions 4, respectively, and there is also an intermediate insulator film 6. Contact holes 7 are provided in the intermediate insulator film 6, and wiring layers 8 are respectively connected to the semiconductor regions 4 or the gate electrodes 3 through the corresponding contact holes 7. Each electrode 5 is made from a composite film and comprises, for example, three layers being a layer of a gold-germanium alloy (Au-Ge), a layer of nickel (Ni) and a layer of gold (Au) in that order from the lowermost layer. These films are first deposited successively by electron beam evaporation and then shaped to a predetermined pattern by a lift-off technique using a resist film. The intermediate insulator film 6 is defined by, e.g., a silicon oxide film formed by a CVD technique. The wiring layer 8 is made from a two-layer film comprising, e.g., a molybdenum (Mo) layer, to improve the adhesion to the silicon oxide film, and a gold (Au) layer deposited thereon. These films are first deposited by electron beam evaporation and then shaped to a predetermined pattern by ion milling.

As described above, the MESFET Qd has a threshold voltage Vth = -1.2 V with which the drain current Ids (the current flowing between the source and drain of the MESFET Qd) does not change or decreases as the junction temperature Tj rises. Since the MESFET Qe is a switching element, the current flowing through the inverter circuit is determined by the MESFET Qd. Since the MESFET Qd is a load element, it is constantly supplied with current. Therefore, the present invention is applied to the MESFET Qd.

It should be noted that, strictly speaking, the junction temperature Tj indicates the temperature at the junction between the electrode 3 and the substrate 1, but, in practice, it may be considered to be the temperature of the substrate (chip) 1.

The present invention is arranged on the basis of the following principle.

The drain current Ids of a MESFET may be expressed by the following equations.

$$Ids = K(Vgs - Vth)^2 \qquad \ldots [1]$$

$$K = \epsilon\mu Wg/2a \cdot Lg \qquad \ldots [2]$$

where: K represents a device constant ($mA/V^2$);

$\epsilon$ represents a dielectric constant; Vgs represents the gate-source (gate bias) voltage (V); $\mu$ represents the mobility of electrons; a represents the depth of the junction at the channel region; Lg represents the gate length (channel length); and Wg represents the gate width.

When equation [1] is applied to the MESFET Qd shown in Fig. 1, the gate-source voltage Vgs is 0 V, and hence equation [1] may be expressed as follows:

$$Ids = K \cdot Vth^2 \qquad \ldots 3$$

The inventors of the present invention measured the drain current Ids and the threshold voltage Vth of a depletion type MESFET made on an experimental basis, and obtained a value for K on the basis of the measured values and in accordance with equation [3]. The MESFET made as a trial had a threshold voltage of -0.8 V when the junction temperature was 25°C. In order to obtain this threshold voltage, silicon ions are implanted at a concentration of $3.5 \times 10^{12}/cm^2$ and at an energy of 75 keV, so that a channel region having a junction depth of 160 nm is formed. The other production conditions are the same as those for the MESFET Qd shown in Fig. 2. The gate-source voltage Vgs of the trial MESFET was OV. It is found that this trial MESFET has characteristics in which, as the junction temperature Tj rises, the drain current Ids also increases, but the absolute value |Vth| of the threshold voltage of the MESFET Qd increases, while the absolute value |K| of the device constant decreases. Thus, when the junction temperature changed from 25°C to 125°C, the threshold voltage changed from -0.8 V to -0.96 V, while the value of K changed from 1.0 to 0.95. It should be noted that the above-described values of K were obtained by substituting the drain current Ids and the threshold voltage Vth which were actually measured into equation [3].

Consequently, it is possible to set the threshold voltage Vth of the MESFET Qd so that, when the gate-source voltage Vgs is 0 V, the drain current Ids does not change or decreases in accordance with a rise in the junction temperature Tj. In other words, when the junction temperature Tj rises, the drain current of the MESFET does not increase within a region where the rate at which the value of K decreases is larger than the rate at which the square of the absolute value of the threshold voltage increases.

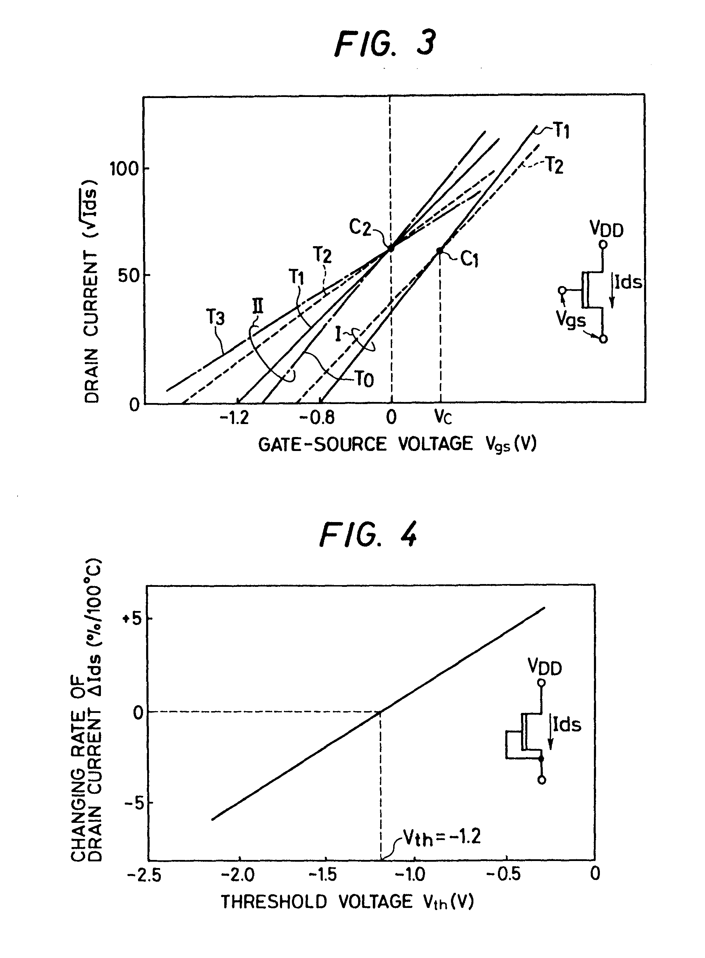

On the basis of this, the inventors of the present invention examined a method of determining a threshold voltage, or setting a gate-source voltage with which the drain current Ids does not increase by performing the experiment shown in Fig. 3.

Fig 3 is a graph showing changes in the drain current Ids occurring when the gate-source voltage Vgs is changed with the junction temperature Tj employed as a parameter.

In this graph, the abscissa represents the gate-source voltage (the gate voltage with respect to the source voltage when used as a reference) Vgs (V), and the ordinate represents the square root of the drain current (μA).

The straight lines forming the group I represent MESFETs with a characteristic whose threshold voltage Vth (the gate-source voltage at which the drain current Ids equals 0) at a junction temperature $T_1$ at an ordinary temperature, i.e., 25°C, is -0.8 V. The straight lines forming the group II, on the other hand, represent MESFETs with a characteristic whose threshold voltage Vth at the junction temperature $T_1$ is -1.2 V. In each of the groups I and II, straight lines $T_1$ and $T_2$ represent MESFET current-voltage characteristics for a relatively low junction temperature $T_1$ (= 25°C) and a relatively high junction temperature $T_2$ (= 125°C), respectively. The MESFETs respectively having threshold voltages Vth of -0.8 V and -1.2 V are produced by production conditions described above.

The voltage-current characteristics of the two MESFETs shown in Fig. 3 are as follows. As the junction temperature Tj rises, the absolute value |Vth| of the threshold voltage also increases. It is clear from the difference between the respective slopes of the straight lines $T_1$ and $T_2$ that, as the junction temperature rises, the absolute value |K| of the device constant decreases. On the basis of such characteristics of |Vth| and |K|, the

straight lines $T_1$ and $T_2$ which respectively represent voltage-current characteristics at two different junction temperatures intersect each other. The straight lines $T_1$ and $T_2$ for a MESFET in group II intersect each other at a point $C_2$, and the gate-source voltage Vgs at this point is 0 V. The straight lines $T_1$ and $T_2$ for a MESFET in group I inter- sect each other at a point $C_1$, and the gate-source voltage Vgs at this point is Vc (V).

The two different MESFETs will be compared with each other below.

A MESFET in group I exhibits a characteristic in which, when the junction temperature is relatively high, i.e., $T_2$, in a state wherein the gate-source voltage Vgs is 0 V, the drain current Ids is larger than that at the relatively low junction temperature $T_1$. A MESFET in group II, on the other hand, exhibits a characteristic in which, even when the junction temperature rises from the rela- tively low value $T_1$ to the relatively high value $T_2$ in a state wherein the gate-source voltage Vgs is 0 V, there is no change in the drain current Ids.

As shown by the one-dot chain lines $T_0$ and $T_3$ for the MESFETs in group II, the experiment carried out by the inventors of the present invention has shown that, in a MESFET of Group II, the voltage-current characteristic straight line $T_0$ for a junction temperature $T_0$ lower than the junction temperature $T_1$ and the voltage-current characteristic straight line $T_3$ for a junction temperature

$T_3$ higher than the junction temperature $T_2$ also cross the intersection $C_2$ between the straight lines $T_1$ and $T_2$. This is the same as for a MESFET in group I, although not shown, and is also the same as MESFETs (respectively having threshold voltages exclusive of -0.8 V and -1.2 V) other than those discussed above.

It should be noted that when a characteristic chart similar to Fig. 3 is prepared for a MESFET having a threshold voltage lower than -1.2 V, the intersection between the voltage-current characteristic straight lines for such a MESFET is located on the left-hand side (as viewed in the figure) of the point of intersection $C_2$ for MESFETs of group II. The intersection for a MESFET having a threshold voltage higher than -0.8 V is located on the right-hand side of the point of intersection $C_1$ for MESFETs of group I.

From the above, it can be appreciated that, in order to form a MESFET in which the drain current Ids does not, at least, increase even when the junction temperature Tj rises, it is desirable that the gate-source voltage Vgs is obtained at which the drain current of a MESFET at the first junction temperature and that at the second junction temperature are equal to each other. Also the MESFET should be used in a region in which the value of the gate-source voltage is larger than the obtained gate-source voltage Vgs. For example, the MESFETs in groups I and II are used in regions where the gate-source voltage Vgs is higher than 0 V and $V_c$ (V), respectively. When the gate-source voltage (the gate bias condition) satisfies such conditions, the temperature dependence of the drain current is zero or negative. In consequence, the temperature dependence of the power dissipation of the MESFET can be negated or made negative. This is effective not only for a depletion type MESFET but also for an enhancement type MESFET. It should be noted that the present invention also includes the situation where the above-described conditions are substantially satisfied, in consideration of possible variations in manufacturing process conditions.

In the inverter circuit shown in the embodiment (see Figs. 1 and 2), the gate-source voltage Vgs is constantly 0 V. Therefore, the gate-source voltage at which the drain current at the first junction temperature and that at the second junction temperature are equal to each other is 0 V or lower.

In other words, as will be clear from the data represented by the group II shown in Fig. 3, the MESFET Qd has a threshold voltage of about -1.2 V, so that the drain current Ids does not change, or a threshold voltage lower than -1.2 V so that the drain current decreases. Alternatively, the drain current Ids may be made to decrease by setting the threshold voltage Vth at -1.2 V and the gate-source voltage Vgs to be greater than 0V. In this case, it is only necessary to insert one or more Schottky barrier diodes between the gate and the source and utilize the forward voltage thereby obtained. Alternatively, a fixed voltage which is sufficiently higher than the source voltage may be applied to the gate. It is a matter of course that the threshold voltage referred to above is the value when the junction temperature is 25°C.

In actual manufacture of the MESFET Qd, it is necessary to consider fluctuations in the process conditions. For example, when the threshold voltage varies within a range of ±0.2 V with respect to a design value due to fluctuations in the process conditions, the threshold voltage of the MESFET Qd shown in Fig. 1 is preferably set at -1.4 V.

Fig. 4 shows the relationship between the threshold voltage $V_{th}$ and the rate of change $\Delta I_{ds}$ of the drain current $I_{ds}$ in accordance with the rise in the junction temperature $T_j$.

The threshold voltage $V_{th}$ of the MESFET Qd can be controlled in accordance with, for example, the junction depth and impurity concentration in the semiconductor region 2A which is employed as a channel region. For this purpose, it is only necessary to vary the dose of silicon ions for implantation as described above. The threshold voltage $V_{th}$ can be lowered by increasing the junction depth of the semiconductor region 2A. The threshold voltage $V_{th}$ of the MESFET Qd may be controlled in accordance with the impurity concentration in the channel region 2A. The threshold voltage $V_{th}$ can be lowered by increasing the

16

impurity concentration in the semiconductor region 2A. The rate of change $\Delta$Ids of the drain current Ids represents the rate of change in the drain current Ids when the junction temperature Tj is raised from 25° to 125° in terms of percentage. The gate-source voltage Vgs is 0 V.

As will be understood from Fig. 4, when the threshold voltage Vth of the MESFET Qd is about -1.2 V with the gate-source voltage Vgs being 0 V, there is no change in the rate of change $\Delta$Ids [%/100°C] of the drain current Ids. When the threshold voltage Vth is set at -1.2 V or less, the rate of change $\Delta$Ids of the drain current Ids decreases.

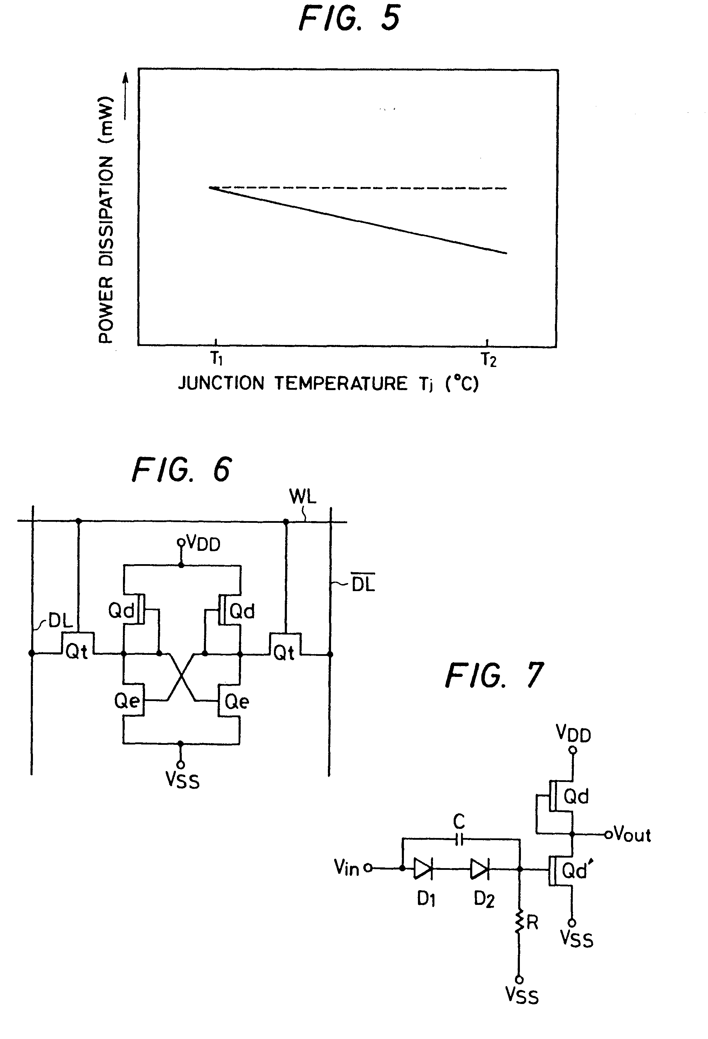

By setting the threshold voltage Vth of the MESFET Qd so that the drain current Ids does not change or decreases as the junction temperature Tj rises, the power dissipation $P_D$ may remain unchanged or may decrease as the junction temperature Tj rises, as shown in Fig. 5. Accordingly, it is possible to prevent thermal run-away, so that the semiconductor integrated circuit device may not be damaged or destroyed. Fig. 5 shows schematically the relationship between the junction temperature Tj °C and the power dissipation $P_D$ mW.

At the Schottky junction between the semiconductor region 2A, which serves as a channel region, and the gate electrode 3 of the MESFET Qd, as the junction temperature Tj rises, the work function $V_F$ is reduced (-1.2 mV/°C), and the leakage current increases, resulting in an increase in the power dissipation $P_D$. However, since the MESFET Qd is arranged such that the drain current Ids does not change or decreases as the junction temperature Tj rises, there is no fear of thermal run-away occurring even when the work function $V_F$ is reduced.

The present invention may also be applied to a semiconductor integrated circuit having a static random-access memory (hereinafter referred to as an "SRAM").

Fig. 6 shows an SRAM memory cell. This memory cell includes a flip-flop which is composed of a pair of inverter circuits each consisting of a depletion type MESFET Qd serving as a load element and an enhancement type MESFET Qe serving as a driving element, which are similar to those in the inverter circuit shown in Fig. 1, the inputs and outputs of the inverter circuits being cross-coupled. Two transfer enhancement type MESFETs Qt for memory selection are respectively provided between a pair of input and output terminals of the flip-flop and a pair of data lines (complementary data lines) DL and $\overline{DL}$. A word line WL is connected to the respective gates of the MESFETs Qt.

Each MESFET Qd in the SRAM memory cell has a threshold voltage Vth which is set so that the drain current Ids does not change or decreases as the junction temperature Tj rises. More specifically, the threshold voltage Vth is set at, for example, about -2.0 V.

The threshold voltage of each of the MESFETs Qe and Qt is set at, for example, about 0.2 V to increase the

18

switching speed.

An SRAM memory cell having the above-described arrangement has advantages similar to those described above. Thus, even when the junction temperature Tj rises, the drain current does not increase, so that thermal run-away can be prevented. In addition, the stand-by (holding) current $I_{SB}$, which is determined by the current flowing through the load MESFET Qd, does not increase. This means that, even when the junction temperature Tj rises, as a result of the rise in the ambient temperature Ta, there is no increase in the stand-by current or the power dissipation of the SRAM. Accordingly, the present invention enables the SRAM to operate over a wide temperature range and also permits a reduction in the power dissipation in the SRAM.

The present invention may also be applied to a semiconductor integrated circuit having an FET Logic with Schottky diode and Coupling capacitor (FLSC) circuit. An FLSC circuit is disclosed in Page 111 - 114 of 1984 GaAs IC Symposium Technical Digest cited as a reference in this specification.

An FLSC circuit is shown in Fig. 7, and is composed of a depletion type MESFET Qd serving as a load element, a depletion type MESFET Qd' serving as a driving element, diodes $D_1$, $D_2$ for level shift, a capacitor element C for speed-up, and a resistor R for absorbing current for the purpose of level shift.

The MESFET Qd in this FLSC circuit has a threshold voltage Vth which is set so that the drain current Ids does not change or decreases as the junction temperature Tj rises in the same manner as discussed above. More specifically, the threshold voltage Vth is set at, for example, about -2.0 V.

The threshold voltage of the MESFET Qd' is set at, for example, about -0.7 V.

As has been described above, it is possible, according to the techniques disclosed in this application, to obtain the following advantages:

(1)     A field-effect transistor in which current is controlled in accordance with the amount by which a depletion layer extends may be formed so that the drain current does not change or decreases as the junction temperature rises, thereby allowing the power dissipation of the field-effect transistor to remain unchanged or to decrease. This can be achieved by appropriately setting the threshold voltage of the field-effect transistor.

(2)     Since thermal-run away may be prevented by virtue of advantage (1), it is possible to prevent damage to and destruction of a semiconductor integrated circuit incorporating such a field-effect transistor.

(3)     The field-effect transistor may operate within a region in which the gate-source voltage is greater than the value of the gate-source voltage at which the drain current at a first junction temperature and that at a second junction temperature are equal to each other, whereby the drain current remains unchanged or decreases as the junction temperature rises.

(4)   The field-effect transistor may have its source and gate shorted and the gate-source voltage at which the drain current at a first junction temperature and that at a second junction temperature are equal to each other be set to 0 V or lower, so that the drain current remains unchanged or decreases as the junction temperature rises.

(5)   In a GaAs MESFET in which the source and gate are shorted, the threshold voltage may be at -1.2 V or lower, so that the drain current remains unchanged or decreases as the junction temperature rises.

Although the present invention has been described in detail by way of the embodiments, the present invention is not limited to those embodiments, and various changes and modifications may be imparted thereto without departing from the present invention.

The present invention may be applied to various types of logic circuit in addition to those shown in Figs. 1 and 7, respectively, and it may also be applicable to any memory cell other than the memory cell of the type shown in Fig. 6.

The present invention is also effective for an enhancement type MESFET. When an enhancement type MESFET is used within a region where the gate-source voltage satisfies the conditions according to the present inven-

**0228764**

tion, the drain current remains unchanged or decreases as the junction temperature rises.

It is also possible, according to the present invention, to obtain a constant-current element having no temperature dependance by controlling either the threshold voltage or the value of the device constant K. Thus the gate-source voltage at which the drain current at a first junction temperature and that a second junction temperature are equal to each other may be derived, and this gate-source voltage employed at all times.

Further, the present invention may also be applied to a MESFET which is formed on a compound semiconductor substrate other than gallium arsenide, such as indium phosphide (InP).

In addition, the present invention may also be applied to a junction type field-effect transistor formed on a single crystal silicon semiconductor substrate. In other words, the present invention may be applicable to any semiconductor integrated circuit, provided that the circuit has a field-effect transistor in which the drain current is controlled in accordance with the amount by which a depletion layer extends.

0228764

CLAIMS:

1.    A semiconductor device provided:

with an FET (Qe,Qd) wherein the current flowing between the source and drain (4) thereof is controlled in accordance with the amount by which a depletion layer extends toward the channel region (2A) thereof in response to the voltage applied to the gate (3) thereof, the FET (Qe,Qd) being used in a region of its characteristic in which the current does not depend on the junction temperature or decreases as the junction temperature rises.

2.    A semiconductor device according to Claim 1, wherein the FET (Qe,Qd) is a MESFET on a gallium arsenide single crystal substrate (1). .

3.    A semiconductor device according to claim 1 or claim 2, wherein the characteristics are obtained by setting the threshold voltage of the FET (Qe,Qd) so that it is lower than a predetermined value.

4.    A semiconductor device according to any one of the preceding claims, wherein the FET (Qd) is of the depletion type, the source and gate thereof being shorted so that it acts as a load element.

5.    A semiconductor device according to claim 1 or claim 2, wherein the characteristics are obtained by setting the gate-source voltage greater than a predetermined value which is a voltage at which the current shows no change at different junction temperatures.

6.    A semiconductor device according to claim 5, wherein the FET (Qe) is of the enhancement type.

7. A semiconductor device according to claim 1 or claim 2, wherein the FET has a gate-source voltage such that the current does not depend on the junction temperature so that the FET acts as a constant-current element.

8. A semiconductor device provided;

with a MESFET (Qd) formed on a compound semiconductor single crystal substrate (1), the gate and source of the MESFET (Qd) being connected together, and the MESFET (Qd) having a threshold voltage of -1.2 V or less when the junction temperature is 25°C.

9. A semiconductor device according to claim 8, wherein the MESFET (Qd) is employed as a load element.

10. A semiconductor device comprising:

a memory cell including a flip-flop constituted by MESFETs (Qe,Qd) formed on a compound semiconductor single crystal substrate (1), the flip-flop being composed of a pair of inverter circuits the input and output terminals of which are cross-coupled, each inverter circuit being constituted by a depletion type MESFET (Qd) the gate and source of which are shorted and which serves as a load element, and an enhancement type MESFET (Qe) which serves as a driving element,

wherein the depletion type MESFET (Qd) has a threshold voltage of -1.2 V or less for a junction temperature of 25°C.

11. A semiconductor device according to any one of claims

24

8 to 10, wherein the compound semiconductor of the substrate is gallium arsenide.

## FIG. 1

V_DD

Qd ↓Ids

○Vout

Vin○─| Qe

V_SS

## FIG. 2

# FIG. 3

# FIG. 4

# FIG. 5

POWER DISSIPATION (mW)

T₁    T₂

JUNCTION TEMPERATURE Tj (°C)

# FIG. 6

# FIG. 7

# EUROPEAN SEARCH REPORT

**European Patent Office**

**0228764**
Application number

EP 86 30 7435

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| X | H. BENEKING: "Feldeffekttransistoren", 1973, pages 207-217, Springer-Verlag, Berlin-Heidelberg-New York, chapter 7.3: "Temperaturverhalten" * Figure 107; egun. (7.19); page 211, last paragraph - page 214, line 3 from the bottom; figure 108 * | 1,3,5 | H 01 L 27/06 H 01 L 29/80 |
| Y | IDEM | 8 | |
| Y | IDEM | 10 | |
| Y | EP-A-0 149 541 (SUMIMOTO ELECTRIC) * Page 3, line 15 - page 5, line 16; figures 1,2,4; page 8, lines 8-14 * | 8 | |
| A | | 2,7,11 | |
| | --- -/- | | |

TECHNICAL FIELDS SEARCHED (Int. Cl 4)

H 01 L

The present search report has been drawn up for all claims

| Place of search | Date of completion of the search | Examiner |
|---|---|---|
| THE HAGUE | 10-02-1987 | MACHEK, J. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82

## EUROPEAN SEARCH REPORT

## DOCUMENTS CONSIDERED TO BE RELEVANT

Page 2

| Category | Citation of document with indication, where appropriate, of relevant passages | Relevant to claim | CLASSIFICATION OF THE APPLICATION (Int Cl 4) |
|---|---|---|---|
| Y | GaAS IC SYMPOSIUM, TECHNICAL DIGEST 1984, Boston, Massachusetts, 23rd-25th October 1984, pages 121-124, IEEE, New York, US; Y. ISHII et al.: "Processing technologies for GaAs memory LSIs" * Page 122, right-hand column, lines 11-23 * | 10 | |
| A | IDEM | 4,6,9, 11 | |
| | | | TECHNICAL FIELDS SEARCHED (Int Cl 4) |

The present search report has been drawn up for all claims

| Place of search | Date of completion of the search | Examiner |
|---|---|---|
| THE HAGUE | 10-02-1987 | MACHEK, J. |